# EUROPÄISCHE PATENTSCHRIFT

(11) **EP 2 210 116 B1**
(45) Veröffentlichungstag und Bekanntmachung des Hinweises auf die Patenterteilung: **06.10.2021**
(21) Anmeldenummer: 08851227.2
(22) Anmeldetag: 16.10.2008
(51) Int. Cl.: G01R 27/28, G01R 31/28

(54) **LEISTUNGSMESSUNG MIT EINEM SIGNALGENERATOR**
POWER MEASUREMENT WITH A SIGNAL GENERATOR
MESURE DE PUISSANCE AVEC UN GÉNÉRATEUR DE SIGNAUX

(30) Priorität: 22.11.2007 DE 102007056268
(43) Veröffentlichungstag der Anmeldung: 28.07.2010
(73) Patentinhaber: Rohde & Schwarz GmbH & Co. KG, 81671 München (DE)
(72) Erfinder: BRAUNSTORFINGER, Thomas, 80796 München (DE); BENISCH, Christian, 86199 Augsburg (DE); KÖHLER, Dieter, 81739 München (DE)
(74) Vertreter: Körfer, Thomas
(86) Internationale Anmeldenummer: PCT/EP2008/008780
(87) Internationale Veröffentlichungsnummer: WO 2009/065473

(56) Entgegenhaltungen:
- EP-A- 0 689 306
- EP-A- 0 776 086
- WO-A-03/071296
- JP-A- 2005 124 128
- US-A- 4 028 637
- US-A- 4 556 841
- US-A- 5 861 882
- US-A1- 2007 052 505
- CHENG-YUNG CHIANG ET AL: "A Simple and Effective Load-Pull System for RF Power Transistor Large-Signal Measurements for Wireless Communication Power Amplifier Design" IEEE TRANSACTIONS ON INSTRUMENTATION AND MEASUREMENT, IEEE SERVICE CENTER, PISCATAWAY, NJ, US, Bd. 46, Nr. 5, 1. Oktober 1997 (1997-10-01), XP011024360 ISSN: 0018-9456

## Beschreibung

Die Erfindung betrifft eine Messvorrichtung und ein Messverfahren mit einem Signalgenerator, welcher mit einem Leistungsmessgerät insbesondere zur Durchführung von Hochfrequenzmessungen verbunden ist.

Herkömmlich wird zur Vermessung von Prüfobjekten (DUT) z. B. mit Netzwerkanalysatoren ein Signal von einem Signalgenerator erzeugt, dem Prüfobjekt beaufschlagt und ein resultierendes Signal von einem Messgerät aufgezeichnet. Aus dem gemessenen Signal ermittelt das Messgerät verschiedene Kennlinien des Prüfobjekts. An diesem Vorgehen ist jedoch nachteilhaft, dass das Messgerät große eigenständige Verarbeitungskapazitäten benötigt, um die Kennlinien zu ermitteln und darzustellen. Weiterhin ist eine effiziente Steuerung der Messung, ohne zusätzliche Geräte, wie zum Beispiel eine Ablaufsteuerung, nicht möglich. Die Messung dauert ohne eine solche Steuerung sehr lange und ist unter Umständen ungenau.

Die EP 0 776 086 B1 zeigt einen Signalgenerator und Messaufbauten zur Ermittlung der Kennlinien von unterschiedlichen Prüfobjekten. Eine eigenständige Verbindung des Signalgenerators mit den eingesetzten Messgeräten ist dabei nicht vorhanden. Die oben geschilderten Schwierigkeiten treten auf.

Die EP 0 689 306 A2 offenbart ein Messsystem mit einem Signalgenerator und einem ersten Leistungsmessgerät. Ein Prüfobjekt wird dabei von dem Signalgenerator mit einem Signal beaufschlagt. Ein von dem Prüfobjekt abgegebenes Signal wird durch das erste Leistungsmessgerät gemessen. Das Messsystem beinhaltet dabei eine Verarbeitungseinheit zur Verarbeitung der Ergebnisse des Leistungsmessgeräts. Darüber hinaus beinhaltet das Messsystem eine Anzeigeeinrichtung zur Darstellung der Messergebnisse.

Die US 2007/0052505 A1 offenbart ein Messsystem, welches einen Signalgenerator und ein Leistungsmessgerät beinhaltet. Ein Messobjekt wird mittels eines durch den Signalgenerator erzeugten Signals beaufschlagt. Das Leistungsmessgerät misst eine Leistung eines abgegebenen Signals des Messobjekts. Der Signalgenerator und der Leistungsmesser werden dabei jeweils über eine Schnittstelle von dem Steuerrechner gesteuert.

Auch das Dokument CHENG-YUNG CHIANG ET AL: "A Simple and Effective Load-Pull System for RF Power Transistor Large-Signal Measurements for Wireless Communication Power Amplifier Design"; IEEE TRANSACTIONS ON INTRUMENTATION AND MEASUREMENT, IEEE SERVICE CENTER, PISCATAWAY, NJ, US, Bd. 46, Nr. 5, 1. Oktober 1997 (1997-10-01), ISSN: 0018-945, Seiten 1150-1155, zeigt ein Messsystem mit einem Signalgenerator, einem Leistungsmesser und einem Steuerrechner. Ein Messobjekt wird von dem Signalgenerator mit einem Signal beaufschlagt. Ein von dem Messobjekt abgegebenes Signal wird von dem Leistungsmesser gemessen. Sowohl der Leistungsmesser wie auch der Signalgenerator werden dabei von dem Steuerrechner gesteuert.

Die US 4,028,627 zeigt die Verwendung eines Zirkulator in einem anderen Zusammenhang.

Der Erfindung liegt die Aufgabe zu Grunde, eine Messvorrichtung und ein Messverfahren zu schaffen, welche mit geringer Messzeit und hoher Genauigkeit Leistungsmessungen durchführen können und dabei geringen wirtschaftlichen Aufwand verursachen.

Die Aufgabe wird erfindungsgemäß für die Vorrichtung durch die Merkmale des unabhängigen Anspruchs 1 und für das Verfahren durch die Merkmale des anderen unabhängigen Anspruchs gelöst. Vorteilhafte Weiterbildungen sind Gegenstand der hierauf rückbezogenen Unteransprüche.

Ein Messsystem beinhaltet einen Signalgenerator und zumindest ein erstes Leistungsmessgerät. Ein Prüfobjekt ist von dem Signalgenerator mit einem Signal beaufschlagbar. Ein von dem Prüfobjekt abgegebenes Signal ist durch das erste Leistungsmessgerät messbar. Dabei sind der Signalgenerator und das Leistungsmessgerät mittels einer bidirektionalen Kommunikationsverbindung verbunden. So ist eine Abstimmung des Leistungsmessgeräts und des Signalgenerators aufeinander möglich. Die Messgenauigkeit wird damit erhöht. Die Messzeit wird damit reduziert.

Die bidirektionale Kommunikationsverbindung erfolgt bevorzugt über einen Bus oder einen Bus und einen Bus-Adapter erfolgt. So ist eine standardisierte Kommunikation gewährleistet. Mittels eines Bus-Adapters können Geräte mit unterschiedlichen Anschlüssen und Kommunikationsverfahren miteinander verbunden werden.

Der Signalgenerator ist bevorzugt über eine zusätzliche Trigger-Leitung mit dem Leistungsmessgerät oder dem Bus-Adapter verbunden. So kann eine genauere Triggerung und damit eine weiter erhöhte Messgenauigkeit erreicht werden. Eine weitere Reduktion der Messzeit kann ebenfalls erzielt werden.

Vorteilhafterweise sind über die bidirektionale Kommunikationsverbindung Parameter des Signals, mit welchem das Prüfobjekt beaufschlagt wird, von dem Signalgenerator an das Leistungsmessgerät übertragbar. So kann das Leistungsmessgerät optimal auf das aktuelle Messsignal eingestellt werden. Eine weitere Erhöhung der Messgenauigkeit wird so erreicht.

Über die bidirektionale Kommunikationsverbindung sind bevorzugt Messwerte und/oder Statusinformationen von dem Leistungsmessgerät an den Signalgenerator übertragbar. Die Statusinformationen zeigen bevorzugt den Abschluss einer Teilmessung und/oder einer gesamten Messung an. So ist eine Weiterverarbeitung der Messwerte durch beide Geräte ermöglicht. Weiterhin wird durch die Mitteilung des Abschlusses der Messung die Messzeit weiter reduziert.

Das Prüfobjekt ist bevorzugt mittels eines Zirkulators an den Signalgenerator angeschlossen. Das erste Leistungsmessgerät ist bevorzugt über den Zirkulator an das Prüfobjekt angeschlossen. Das von dem Prüfobjekt reflektierte Signal ist bevorzugt von dem Leistungsmessgerät messbar. So können vom Prüfobjekt reflektierte Signale gemessen werden. Die Aufnahme einer Reflektions-Kennlinie ist möglich.

Der Signalgenerator beinhaltet bevorzugt eine Anzeigeeinrichtung und eine Verarbeitungseinrichtung. Vorteilhafterweise sind die Ergebnisse der Messung des Leistungsmessgeräts an den Signalgenerator übertragbar. Die Ergebnisse der Messung des Leistungsmessgeräts sind bevorzugt von der Verarbeitungseinrichtung verarbeitbar und bevorzugt von der Anzeigeeinrichtung anzeigbar. So können die Messergebnisse klar und verständlich dargestellt werden. Ein Einsatz von preiswerten Leitungsmessgeräten, welche nicht über eine eigene Verarbeitungseinrichtung und eine eigene Anzeigeeinrichtung verfügen, ist so möglich.

Vorteilhafterweise ist der Ablauf einer Messung gemeinsam von dem Signalgenerator und dem Leistungsmessgerät steuerbar. Durch ein solches gegenseitiges Verfahren wird die Messzeit optimiert. Weiterhin werden Messfehler auf Grund von Statusunterschieden der Geräte vermieden.

Das erste Leistungsmessgerät ist bevorzugt ein frequenzselektives Leistungsmessgerät. So kann die Messgenauigkeit weiter erhöht werden. Weiterhin ist die Anforderung an die Steilheit der Ausgangsfilter des Signalgenerators so reduziert. Frequenzveränderndes Verhalten des Prüfobjekts kann so ermittelt werden.

Mit dem Messsystem ist vorteilhafterweise eine AM-AM Kennlinie bestimmbar. So können mit einem einfachen Messaufbau skalare Kennlinien ermittelt werden.

Mehrere Leistungsmessgeräte sind bevorzugt mittels bidirektionaler Kommunikationsverbindungen mit dem Signalgenerator verbunden. Mehrere von dem Prüfobjekt abgegebene Signale sind bevorzugt von den mehreren Leistungsmessgeräten messbar. So kann durch die gleichzeitige Messung eine Verkürzung des Messzeit durch Parallelisierung erreicht werden. Weiterhin ist bei nichtperiodischen Signalen eine synchrone Messung möglich.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: ein erstes nicht erfindungsgemäßes Beispiel eines Messsystems;
- Fig. 2: ein zweites nicht erfindungsgemäßes Beispiel eines Messsystems, und
- Fig. 3: ein Ausführungsbeispiel des erfindungsgemäßen Messsystems.

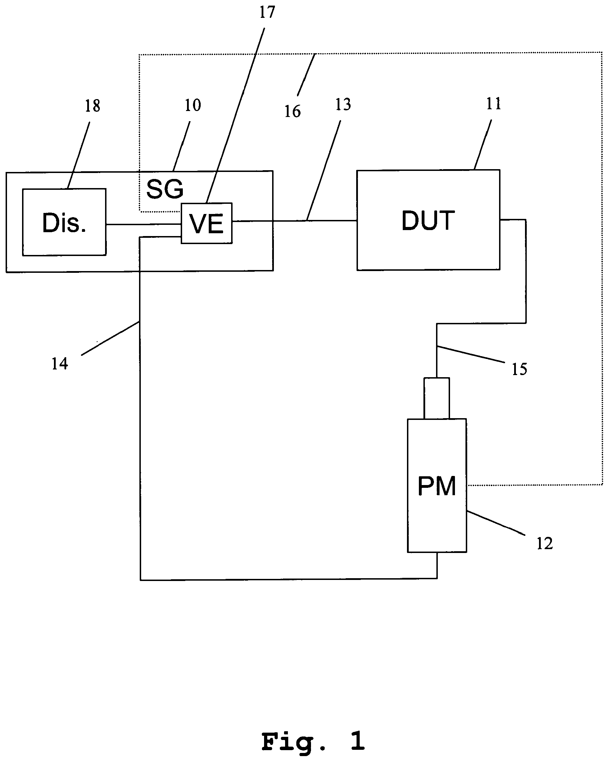

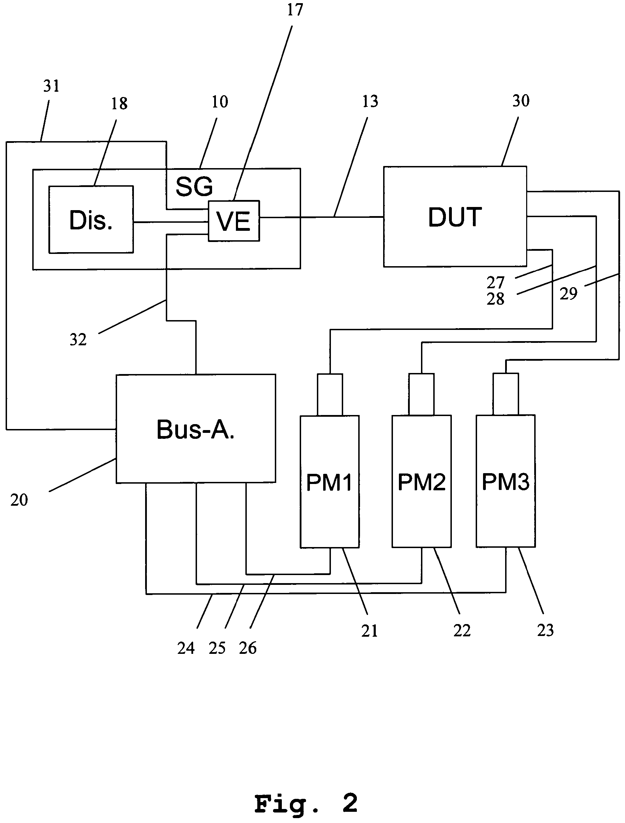

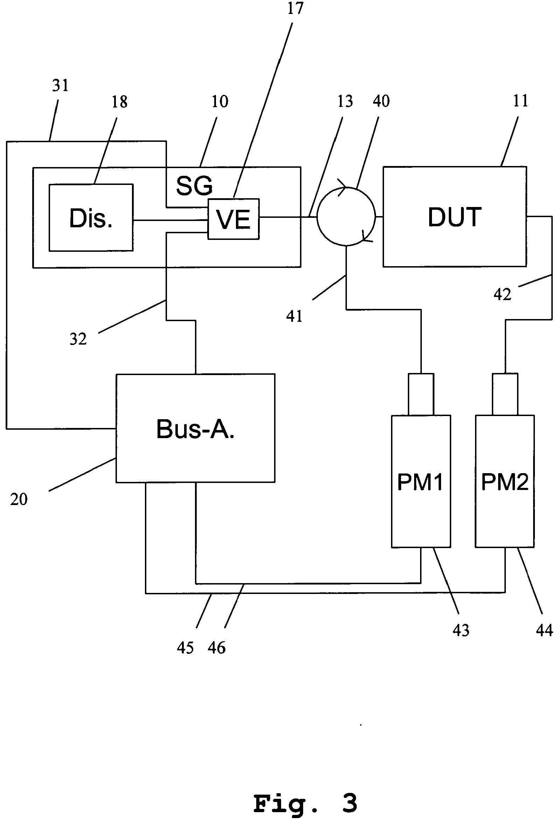

Anhand der Fig. 1 und 2 wird der Aufbau und die Funktionsweise verschiedener Beispiele und anhand von Fig. 3 eines erfindungsgemäßen Ausführungsbeispiels von Messsystemen und Verfahren gezeigt. Identische Elemente wurden in ähnlichen Abbildungen zum Teil nicht wiederholt dargestellt und beschrieben.

Fig. 2 zeigt ein erstes Beispiel eines nicht erfindungsgemäßen Messsystems. Ein Signalgenerator 10 ist mittels einer Hochfrequenzübertragungsleitung 13 mit einem Prüfobjekt 11 verbunden. Das Prüfobjekt 11 ist mittels einer weiteren Hochfrequenzübertragungsleitung 15 mit einem Leistungsmessgerät 12 verbunden. Das Leistungsmessgerät 12 ist mittels eines digitalen Bus 14 mit dem Signalgenerator 10 verbunden. Der Bus ist bevorzugt ein USB-Bus. Weiterhin ist der Signalgenerator 10 mittels einer Triggerleitung 16 mit dem Leistungsmessgerät 12 verbunden.

Der Signalgenerator 10 überträgt über die erste Hochfrequenzübertragungsleitung 13 ein Eingangssignal an das Prüfobjekt 11. Das Prüfobjekt 11 wird durch das Eingangssignal zur Abgabe eines Ausgangssignals angeregt. Dieses Ausgangssignal wird über die Hochfrequenzübertragungsleitung 15 an das Leistungsmessgerät 12 übertragen. Das Leistungsmessgerät 12 misst die Leistung des Signals und überträgt das Ergebnis über den digitalen Bus 14 an den Signalgenerator 10.

Dabei teilt der Signalgenerator 10 dem Leistungsmessgerät 12 über den digitalen Bus 14 im Beispiel den aktuellen Messpunkt in Amplitude und Frequenz mit. Dies ermöglicht dem Leistungsmessgerät 12 die Einstellung von internen Filtern je nach gewählter Frequenz und/oder die Einstellung von internen Messzweigen je nach zu erwartender Amplitude. Der Beginn der Messung des aktuellen Messpunkts wird entweder über den digitalen Bus 14 oder über die Triggerleitung 16 signalisiert. Nach Abschluss der Messung des aktuellen Messpunkts teilt das Leistungsmessgerät 12 dem Signalgenerator 10 das Ende der Messung mit, wodurch der Signalgenerator 10 in die Lage versetzt wird, mit dem folgenden Messpunkt fortzufahren. Die an den Signalgenerator 10 übermittelten Messwerte werden von diesem in einer Verarbeitungseinrichtung 17 weiterverarbeitet und auf einer Anzeigeeinrichtung 18 dargestellt. Die Verarbeitungseinrichtung 17 ist ebenfalls für die Erzeugung des Triggersignals und des Eingangssignals zuständig.

Fig. 2 zeigt ein zweites nicht erfindungsgemäßes Beispiel des Messsystems. Ein Signalgenerator 10 ist mittels einer Hochfrequenzübertragungsleitung 13 mit einem Prüfobjekt 30 verbunden. Das Prüfobjekt 30 verfügt über mehrere Messpunkte, an welchem unterschiedliche Ausgangssignale anliegen. Über die

Hochfrequenzübertragungsleitungen 27, 28 und 29 ist das Prüfobjekt 30 mit den Leistungsmessgeräten 21, 22 und 23 verbunden. Diese sind mittels des digitalen Bus 24, 25 und 26 mit einem Bus-Adapter 20 verbunden. Der Bus-Adapter 20 ist mittels des digitalen Bus 32 mit dem Signalgenerator 10 verbunden. Auch hier handelt es sich bevorzugt um einen USB-Bus. Weiterhin ist der Bus-Adapter 20 über eine Triggerleitung 31 ebenfalls mit dem Signalgenerator 10 verbunden. Der Signalgenerator 10 überträgt über die Hochfrequenzübertragungsleitung 13 ein Eingangssignal an das Prüfobjekt 30. Eine Übertragung mehrerer unterschiedlicher Eingangsignale über mehrere Hochfrequenzübertragungsleitungen ist ebenso denkbar.

Durch das Eingangssignal wird das Prüfobjekt 30 zur Abgabe mehrerer Ausgangssignale angeregt. Die mehreren Ausgangssignale werden von den Hochfrequenzübertragungsleitungen 27, 28 und 29 an die Leistungsmessgeräte 21, 22 und 23 übertragen. Die Leistungsmessgeräte 21, 22, und 23 messen die Leistung der Signale und übertragen diese jeweils über den zugeordneten digitalen Bus 24, 25 und 26 an den Bus-Adapter 20, welcher die Messwerte über den digitalen Bus 32 an den Signalgenerator 10 überträgt. Über die Triggerleitung 31 zeigt der Signalgenerator 10 dem Bus-Adapter 20 und damit auch den Leistungsmessgeräten 21, 22 und 23 den Beginn einer Messung beziehungsweise Teilmessung an.

Weiterhin überträgt der Signalgenerator 10 über den digitalen Bus 32 die Lage des aktuellen Messpunkts in Frequenz und Amplitude an den Bus-Adapter 20 und weiter über den digitalen Bus 24, 25 und 26 an die Leistungsmessgeräte 21, 22 und 23. Nach Beendigung der Messung des aktuellen Messpunkts wird dieser Umstand über den digitalen Bus 24, 25 und 26, den Bus-Adapter 20 und den digitalen Bus 32 an den Signalgenerator 10 übermittelt. Dieser kann nun mit dem folgenden Messpunkt fortfahren. Die an den Signalgenerator 10 übermittelten Messwerte werden von diesem in einer Verarbeitungseinrichtung 17 weiterverarbeitet und auf einer Anzeigeeinrichtung 18 dargestellt. Die Verarbeitungseinrichtung 17 ist ebenfalls für die Erzeugung des Triggersignals und des Eingangssignals zuständig.

Fig. 3 zeigt ein Ausführungsbeispiel der erfindungsgemäßen Vorrichtung. Ein Signalgenerator 10 ist mittels einer Hochfrequenzübertragungsleitung 13 mit einem Zirkulator 40 verbunden. Der Zirkulator 40 ist mit einem Prüfobjekt 11 verbunden. Weiterhin ist der Zirkulator 40 über eine Hochfrequenzübertragungsleitung 41 mit einem ersten Leistungsmessgerät 43 verbunden. Das Prüfobjekt 11 ist mittels einer Hochfrequenzübertragungsleitung 42 mit einem zweiten Leistungsmessgerät 44 verbunden. Die Leistungsmessgeräte 43 und 44 sind mittels jeweils einem digitalen Bus 45 und 46 z. B. eines USB-Bus mit dem Bus-Adapter 20 verbunden. Der Bus-Adapter 20 ist mittels des digitalen Bus 32 z. B. eines USB-Bus mit dem Signalgenerator 10 verbunden. Weiterhin ist der Bus-Adapter 20 mittels einer Triggerleitung 31 ebenfalls mit dem Signalgenerator 10 verbunden.

Der Signalgenerator 10 beaufschlagt das Prüfobjekt 11 über die Hochfrequenzübertragungsleitung 13 und den Zirkulator 40 mit einem Eingangssignal. Hierdurch wird das Prüfobjekt 11 zur Ausgabe eines Ausgangssignals angeregt. Dieses Ausgangssignal wird von dem Leistungsmessgerät 44 gemessen. Weiterhin reflektiert das Prüfobjekt 11 einen Teil des Eingangssignals. Dieses reflektierte Signal wird von den Zirkulator 40 und der Hochfrequenzübertragungsleitung 41 an das Leistungsmessgerät 43 übertragen und von diesem gemessen. Die von den Leistungsmessgeräten 43, 44 gemessenen Werte werden über den digitalen Bus 45, 46 an den Bus-Adapter 20 übertragen. Der Bus-Adapter 20 überträgt die Messwerte über den digitalen Bus 32 an den Signalgenerator 10.

Der Signalgenerator 10 signalisiert den Leistungsmessgeräten 43, 44 über die Triggerleitung 31, den Bus-Adapter 20 und den digitalen Bus 45, 46 den Beginn der Messungen beziehungsweise der Teilmessungen. Über den digitalen Bus 32, den Bus-Adapter 20 und den digitalen Bus 45, 46 wird weiterhin die Lage des aktuellen Messpunkt in Frequenz und Amplitude an die Leistungsmessgeräte 43, 44 übertragen. Die Leistungsmessgeräte 43, 44 übertragen im Gegenzug neben den Messwerten den Zeitpunkt des Abschlusses der Messung des aktuellen Messpunkts. Somit ist der Signalgenerator 10 in der Lage, mit dem folgenden Messpunkt fortzufahren. Die an den Signalgenerator 10 übermittelten Messwerte werden von diesem in einer Verarbeitungseinrichtung 17 weiterverarbeitet und auf einer Anzeigeeinrichtung 18 dargestellt. Die Verarbeitungseinrichtung 17 ist ebenfalls für die Erzeugung des Triggersignals und des Eingangssignals zuständig.

Die Erfindung ist nicht auf das dargestellte Ausführungsbeispiel beschränkt. Wie bereits erwähnt, können unterschiedliche Leistungsmessgeräte an dem Signalgenerator angeschlossen werden. Ebenso ist eine Messung unterschiedlicher Kennlinien und Einzelwerte möglich. Auch eine Vermessung des Ausgangssignals des Signalgenerators zur Kalibrierung mit einer einfachen durchkontaktierten Adapterleitung als Prüfobjekt ist denkbar.

## Patentansprüche

1. Messsystem mit einem Signalgenerator (10) und zumindest einem ersten Leistungsmessgerät (43) und einem zweiten Leistungsmessgerät (44),
wobei ein Prüfobjekt (11) von dem Signalgenerator (10) mit einem Signal beaufschlagbar ist,
wobei ein jeweiliges von dem Prüfobjekt (11) abgegebenes Signal durch das erste Leistungsmessgerät (43) und das zweite Leistungsmessgerät (44) messbar ist, und
wobei der Signalgenerator (10) und das erste Leistungsmessgerät (43) und das zweite Leistungsmessgerät (44) mittels einer bidirektionalen Kommunikationsverbindung verbunden sind,
**dadurch gekennzeichnet,**
**dass** das Prüfobjekt (11) mittels eines Zirkulators (40) an den Signalgenerator (10) angeschlossen ist,
**dass** das erste Leistungsmessgerät (43) über eine erste Hochfrequenzübertragungsleitung (41) und den Zirkulator (40) an das Prüfobjekt (11) angeschlossen ist,
**dass** das von dem Prüfobjekt (11) reflektierte Signal von dem ersten Leistungsmessgerät (43) messbar ist, und
**dass** das Prüfobjekt (11) mittels einer zweiten Hochfrequenzübertragungsleitung (42) mit einem zweiten Leistungsmessgerät (44) verbunden ist,
**dass** die bidirektionale Kommunikationsverbindung über einen Bus-Adapter (20) und einen Bus (45, 46) zwischen dem Bus-Adapter (20) und den Leistungsmessgeräten (43, 44) erfolgt, und
**dass** der Signalgenerator (10) über eine zusätzliche Trigger-Leitung (31) mit dem Bus-Adapter (20) verbunden ist.

2. Messsystem nach Anspruch 1,
**dadurch gekennzeichnet,**
**dass** das erste Leistungsmessgerät (43) ein frequenzselektives Leistungsmessgerät ist.

3. Messverfahren mit einem Signalgenerator (10) und zumindest einem ersten Leistungsmessgerät (43) und einem zweiten Leistungsmessgerät (44),
wobei ein Prüfobjekt (11) von dem Signalgenerator (10) mit einem Signal beaufschlagt wird,
wobei ein jeweiliges von dem Prüfobjekt (11) abgegebenes Signal durch das erste Leistungsmessgerät (43) und das zweite Leistungsmessgerät (44) gemessen wird, und
wobei der Signalgenerator (10) und das erste Leistungsmessgerät (43) und das zweite Leistungsmessgerät (44) mittels einer bidirektionalen Kommunikationsverbindung kommunizieren,
**dadurch gekennzeichnet,**
**dass** das Prüfobjekt (11) mittels eines Zirkulators (40) an den Signalgenerator (10) angeschlossen wird,
**dass** das erste Leistungsmessgerät (43) über eine erste Hochfrequenzübertragungsleitung (41) und den Zirkulator (40) an das Prüfobjekt (11) angeschlossen wird,
**dass** das von dem Prüfobjekt (11) reflektierte Signal von dem Zirkulator (40) über die erste Hochfrequenzübertragungsleitung (41) an das erste Leistungsmessgerät (43) übertragen wird,
**dass** das erste Leistungsmessgerät (43) das am Prüfobjekt (11) reflektierte Signal misst,
**dass** das Prüfobjekt (11) mittels einer zweiten Hochfrequenzübertragungsleitung (42) mit einem zweiten Leistungsmessgerät (44) verbunden wird,
**dass** der Signalgenerator (10) das Prüfobjekt (11) über eine dritte Hochfrequenzübertragungsleitung (13) und den Zirkulator (40) mit einem Eingangssignal beaufschlagt und hierdurch das Prüfobjekt (11) zur Ausgabe eines Ausgangssignals angeregt wird, wobei dieses Ausgangssignal von dem zweiten Leistungsmessgerät (44) gemessen wird,
**dass** die bidirektionale Kommunikationsverbindung über einen Bus-Adapter (20) und einen Bus (45, 46) zwischen den Bus-Adapter (20) und den Leistungsmessgeräten (43, 44) erfolgt, und
**dass** das Leistungsmessgerät (43, 44) über eine zusätzliche Trigger-Leitung (31) von dem Signalgenerator (10) zu dem Bus-Adapter (20)getriggert wird.

4. Messverfahren nach Anspruch 3,
**dadurch gekennzeichnet,**
**dass** der Signalgenerator (10) eine Anzeigeeinrichtung (18) und eine Verarbeitungseinrichtung (17) beinhaltet,
**dass** die Ergebnisse der Messung der Leistungsmessgeräte (43, 44) an den Signalgenerator (10) übertragen werden,
**dass** die Ergebnisse der Messung der Leistungsmessgeräte (43, 44) von der Verarbeitungseinrichtung (17) verarbeitet werden, und
**dass** die Ergebnisse der Messung der Leistungsmessgeräte (43, 44) von der Anzeigeeinrichtung (18) angezeigt werden.

5. Messverfahren nach Anspruche 3 oder 4,
**dadurch gekennzeichnet,**
**dass** der Ablauf einer Messung gemeinsam von dem Signalgenerator (10) und dem Leistungsmessgerät (43, 44) gesteuert wird.

6. Messverfahren nach einem der Ansprüche 3 bis 5,
**dadurch gekennzeichnet,**
**dass** das erste Leistungsmessgerät (43) ein frequenzselektives Leistungsmessgerät ist.

## Claims

1. A measuring system with a signal generator (10) and at least a first power meter (43) and a second power meter (44), wherein the signal generator (10) can apply a signal to a test object (11), wherein a respective signal emitted by the test object (11) can be measured by the first power meter (43) and the second power meter (44), and wherein the signal generator (10) and the first power meter (43) and the second power meter (44) are connected by means of a bidirectional communication link, **characterized in that** the test object (11) is connected to the signal generator (10) by means of a circulator (40), that the first power meter (43) is connected to the test object (11) via a first high-frequency transmission line (41) and the circulator (40), that the signal reflected by the test object (11) can be measured by the first power meter (43), and that the test object (11) is connected to a second power meter (44) by means of a second high-frequency transmission line (42), that the bidirectional communication link occurs via a bus adapter (20) and a bus (45, 46) between the bus adapter (20) and the power meters (43, 44), and that the signal generator (10) is connected to the bus adapter (20) via an additional trigger line (31) .

2. The measuring system according to claim 1, **characterized in that** the first power meter (43) is a frequency-selective power meter.

3. A measuring method with a signal generator (10) and at least a first power meter (43) and a second power meter (44), wherein the signal generator (10) applies a signal to a test object (11), wherein a respective signal emitted by the test object (11) is measured by the first power meter (43) and the second power meter (44), and wherein the signal generator (10) and the first power meter (43) and the second power meter (44) communicate by means of a bidirectional communication link, **characterized in that** the test object (11) is connected to the signal generator (10) via a first high-frequency transmission line (41) and the circulator (40), that the first power meter (43) is connected to the test object (11) via a first high-frequency transmission line (41) and the circulator (40), that the signal reflected by the test object (11) is transmitted by the circulator (40) via the first high-frequency transmission line (41) to the first power meter (43), that the first power meter (43) measures the signal reflected on the test object (11), that the test object (11) is connected to a second power meter (44) by means of a second high-frequency transmission line (42), that the signal generator (10) applies an input signal to the test object (11) via a third high-frequency transmission line (13) and the circulator (40) and as a result the test object (11) is induced to output an output signal, wherein this output signal is measured by the second power meter (44), that the bidirectional communication link occurs via a bus adapter (20) and a bus (45, 46) between the bus adapter (20) and the power meters (43, 44), and that the power meter (43, 44) is triggered via an additional trigger line (31) from the signal generator (10) to the bus adapter (20).

4. The measuring method according to claim 3, **characterized in that** the signal generator (10) contains a display device (18) and a processing device (17), that the results of the measurement of the power meters (43, 44) is transmitted to the signal generator (10), that the results of the measurement of the power meters (43, 44) are processed by the processing device (17), and that the results of the measurement of the power meters (43, 44) are displayed by the display device (18).

5. The measuring method according to claims 3 or 4, **characterized in that** the course of a measurement is controlled jointly by the signal generator (10) and the power meter (43, 44) .

6. The measuring method according to any of claims 3 to 5, **characterized in that** the first power meter (43) is a frequency-selective power meter.

## Revendications

1. Système de mesurage avec un générateur de signal (10) et au moins un premier wattmètre (43) et un second wattmètre (44),
dans lequel un objet en essai (11) peut être sollicité avec un signal par un générateur de signal (10),
dans lequel un signal respectif fourni par l'objet en essai (11) peut être mesuré par le premier wattmètre (43) et le second wattmètre (44), et
dans lequel le générateur de signal (10) et le premier wattmètre (43) et le second wattmètre (44) sont reliés au moyen d'une liaison de communication bidirectionnelle,
**caractérisé en ce que**
l'objet en essai (11) est raccordé au générateur de signal (10) au moyen d'un circulateur (40),
le premier wattmètre (43) est raccordé à l'objet en essai (11) via une première ligne de transmission haute fréquence (41) et le circulateur (40),
le signal réfléchi par l'objet en essai (11) peut être mesuré par le premier wattmètre (43), et
l'objet en essai (11) est relié à un second wattmètre (44) au moyen d'une deuxième ligne de transmission haute fréquence (42),
la liaison de communication bidirectionnelle se produit via un adaptateur de bus (20) et un bus (45, 46) entre l'adaptateur de bus (20) et les wattmètres (43, 44), et
le générateur de signal (10) est relié à l'adaptateur de bus (20) via une ligne de déclenchement (31) supplémentaire.

2. Système de mesurage selon la revendication 1,
**caractérisé en ce que**
le premier wattmètre (43) est un wattmètre sélectif en fréquence.

3. Procédé de mesurage avec un générateur de signal (10) et au moins un premier wattmètre (43) et un second wattmètre (44),
dans lequel un objet en essai (11) est sollicité avec un signal par un générateur de signal (10),
dans lequel un signal respectif fourni par l'objet en essai (11) est mesuré par le premier wattmètre (43) et le second wattmètre (44), et
dans lequel le générateur de signal (10) et le premier wattmètre (43) et le second wattmètre (44) communiquent au moyen d'une liaison de communication bidirectionnelle,
**caractérisé en ce que**
l'objet en essai (11) est raccordé au générateur de signal (10) au moyen d'un circulateur (40),
le premier wattmètre (43) est raccordé à l'objet en essai (11) via une première ligne de transmission haute fréquence (41) et le circulateur (40),
le signal réfléchi par l'objet en essai (11) est transmis au premier wattmètre (43) par le circulateur (40) via la première ligne de transmission haute fréquence (41),
le premier wattmètre (43) mesure le signal réfléchi au niveau de l'objet en essai (11),
l'objet en essai (11) est relié à un second wattmètre (44) au moyen d'une deuxième ligne de transmission haute fréquence (42),
le générateur de signal (10) sollicite l'objet en essai (11) avec un signal d'entrée via une troisième ligne de transmission haute fréquence (13) et le circulateur (40), et ce faisant l'objet en essai (11) est stimulé pour émettre un signal de sortie, dans lequel ce signal de sortie est mesuré par le second wattmètre (44),
la liaison de communication bidirectionnelle se produit via un adaptateur de bus (20) et un bus (45, 46) entre l'adaptateur de bus (20) et les wattmètres (43, 44), et
le wattmètre (43, 44) est déclenché depuis le générateur de signal (10) vers l'adaptateur de bus (20) via une ligne de déclenchement (31) supplémentaire.

4. Procédé de mesurage selon la revendication 3,
**caractérisé en ce que**
le générateur de signal (10) contient un équipement d'affichage (18) et un équipement de traitement (17),
les résultats du mesurage des wattmètres (43, 44) sont transmis au générateur de signal (10),
les résultats du mesurage des wattmètres (43, 44) sont traités par l'équipement de traitement (17), et
les résultats du mesurage des wattmètres (43, 44) sont affichés par l'équipement d'affichage (18).

5. Procédé de mesurage selon la revendication 3 ou 4,
**caractérisé en ce que**
le déroulement d'un mesurage est commandé ensemble par le générateur de signal (10) et le wattmètre (43, 44).

6. Procédé de mesurage selon l'une des revendications 3 à 5,
**caractérisé en ce que**
le premier wattmètre (43) est un wattmètre sélectif en fréquence.
